# DEMANDE DE BREVET EUROPEEN

(11) **EP 4 769 947 A2**
(43) Date de publication de la demande: **01.07.2026**
(21) Numéro de dépôt: 25315418.1
(22) Date de dépôt: 27.11.2025
(51) Int. Cl.: H03K 17/60, H03K 17/62

(54) **CIRCUIT DE COMMUTATION**

(30) Priorité: 09.12.2024 EP 24315560
(71) Demandeur: STMicroelectronics International N.V., 1228 Plan-les-Ouates, Geneva (CH)
(72) Inventeur: Knopik, Vincent, 38830 CRETS EN BELLEDONNE (FR); Butaye, Benoît, 38240 MEYLAN (FR)
(74) Mandataire: Cabinet Beaumont

(57) **Abrégé**

La présente description porte sur un circuit de commutation (205) comprenant au moins un premier transistor bipolaire configuré pour être couplé à au moins un composant électrique (106, 109, 506, 507) à commuter, le transistor bipolaire (60) ayant une première électrode de conduction couplée à un potentiel électrique de référence par l'intermédiaire d'au moins un composant résistif (61) ou inductif ou un deuxième transistor (71).

## Description

### Domaine technique

La présente description concerne de façon générale le domaine des circuits de commutation, ou « switch » en anglais, des commutateurs, et des multiplexeurs mettant en œuvre ces circuits de commutation et commutateurs.

### Technique antérieure

Des composants électriques à valeur variable, tels que des résistances variables, des capacités variables, ou des inductances variables peuvent être obtenus en utilisant un ou plusieurs commutateurs ou interrupteurs, pour augmenter ou diminuer graduellement la valeur de ces composants en fonction de l'état fermé ou ouvert de ses commutateurs ou interrupteurs.

Les commutateurs ou interrupteurs utilisés pour créer des composants à valeur variable sont de taille élevée pour assurer une résistance à l'état passant qui soit la lus faible possible et présentent également une capacité parasite qui impacte la réponse fréquentielle du composant à valeur variable.

Parallèlement, la réduction des surfaces de puce consacrées aux signaux radiofréquences implique de pouvoir sélectionner ou changer la charge, les valeurs d'inductance des transformateurs, ou encore les entrées/sorties. Il est donc important de pouvoir disposer de multiplexeurs pour effectuer ses sélections.

### Résumé de l'invention

Il existe un besoin de fournir une solution permettant d'obtenir des commutateurs pour composant à valeur variable qui puisse être de taille inférieure et permettre de diminuer l'impact de leur capacité parasite.

Il existe en outre un besoin de disposer de multiplexeurs qui puissent fonctionner avec peu de pertes, sur des surfaces de puces faibles et à des coûts faibles, dans le domaine des domaines de haute fréquence de l'ordre de la dizaine de GHz.

Un mode de réalisation pallie tout ou partie de ces inconvénients en proposant un nouveau type de circuit de commutation.

Un mode de réalisation prévoit un circuit de commutation comprenant au moins un premier transistor bipolaire configuré pour être couplé à au moins un composant électrique à commuter, le transistor bipolaire ayant une première électrode de conduction couplée à un potentiel électrique de référence par l'intermédiaire d'au moins un composant résistif ou inductif ou un deuxième transistor.

Selon un mode de réalisation :
- le transistor bipolaire est de type NPN ; et/ou
- la première électrode de conduction dudit au moins un transistor bipolaire correspond à l'émetteur du transistor bipolaire ; et/ou
- le circuit de commutation comporte en outre une première résistance électrique dont une première borne est couplée à une base du transistor bipolaire et dont une deuxième borne est configurée pour être reliée à un rail d'application d'un premier signal de commande; et/ou
- ledit composant résistif ou inductif correspond à une deuxième résistance électrique ou une inductance, et comporte une première borne couplée à la première électrode de conduction du transistor bipolaire et une deuxième borne couplée audit potentiel électrique de référence ; et/ou
- la première électrode de conduction du transistor bipolaire est couplée à une première borne de conduction du deuxième transistor, et dans lequel une deuxième borne de conduction du deuxième transistor, par exemple de type NMOS ou PMOS, est couplée au potentiel électrique de référence.

Selon un mode de réalisation le circuit de commutation comporte en outre une troisième résistance électrique dont une première borne est couplée à une électrode de commande du deuxième transistor et dont une deuxième borne est reliée à un rail d'application d'un deuxième signal de commande.

Selon un mode de réalisation, les premiers et deuxièmes signaux de commande correspondent à un même signal de commande ou à deux signaux simultanés.

Selon un mode de réalisation :
- ladite première électrode dudit au moins un transistor bipolaire est configurée pour être couplée audit composant électrique à commuter ; et/ou
- une deuxième électrode dudit au moins un transistor bipolaire est configurée pour être couplée à un autre composant électrique à commuter.

Selon un mode de réalisation, ledit potentiel électrique de référence est la masse.

Un mode de réalisation prévoit un composant à valeur contrôlable, comprenant :
- un premier circuit de commutation tel que décrit plus haut ; et
- un premier composant électrique à commuter, couplé à la première ou à une deuxième électrode dudit au moins un transistor bipolaire dudit premier circuit de commutation ; ledit premier composant électrique à commuter correspondant à une capacité électrique ou une résistance électrique ou une inductance ou un transistor.

Selon un mode de réalisation, le composant à valeur contrôlable comprend un deuxième composant électrique à commuter, couplé à la deuxième électrode dudit au moins un transistor bipolaire dudit premier circuit de commutation ;
ledit premier composant électrique à commuter étant couplé à la première électrode dudit au moins un transistor bipolaire dudit premier circuit de commutation ;
ledit deuxième composant électrique à commuter correspondant à une capacité électrique ou une résistance électrique ou une inductance ou un transistor.

Un mode de réalisation prévoit un commutateur comprenant :
- un premier circuit de commutation tel que décrit plus haut ; et
- un premier composant électrique à commuter, couplé à la deuxième électrode dudit au moins un transistor bipolaire dudit premier circuit de commutation ;
ledit premier composant électrique à commuter correspondant à une première inductance en série avec une deuxième inductance.

Selon un mode de réalisation du commutateur, une capacité relie un point milieu des premières et deuxièmes inductances à la masse.

Selon un mode de réalisation du commutateur, la deuxième électrode dudit au moins un transistor bipolaire et une première borne de la première inductance, différente d'une deuxième borne de la première inductance reliée au point milieu des premières et deuxièmes inductances, sont configurées pour être reliées à un premier nœud de réception ou d'application d'un signal différentiel.

Selon un mode de réalisation, le commutateur comprend un deuxième transistor bipolaire ayant :
- un émetteur relié à la première électrode dudit au moins un transistor bipolaire dudit premier circuit de commutation ; et
- un collecteur relié à une borne de la deuxième inductance, différente d'une autre borne reliée au point milieu, et à un deuxième nœud d'application ou de réception dudit signal différentiel.

Selon un mode de réalisation du commutateur, une quatrième résistance relie la base dudit deuxième transistor bipolaire et le rail d'application du premier signal de commande.

Un mode de réalisation prévoit un multiplexeur, comprenant :
- plusieurs commutateurs tels que décrits plus haut ;
- une pluralité de groupes d'inductances en série (706, 707, 708, 709) entre deux nœuds de sortie du multiplexeur ;
chaque groupe d'inductance étant agencé de sorte qu'un couplage électromagnétique puisse se créer respectivement entre la première inductance d'un desdits commutateurs et une inductance du groupe ainsi qu'entre la deuxième inductance dudit commutateur et une autre inductance dudit groupe.

Selon un mode de réalisation, le multiplexeur comprend :
- au moins un premier commutateur tel que décrit plus haut ;
- au moins un deuxième commutateur tel que décrit plus haut ;

des troisièmes, quatrièmes, cinquièmes et sixièmes inductances en série (706, 707, 708, 709) entre les nœuds de sortie du multiplexeur ;
les troisièmes et quatrièmes inductances étant agencées de sorte qu'un couplage électromagnétique puisse se créer respectivement entre la première inductance du premier commutateur et la troisième inductance ainsi qu'entre la deuxième inductance du premier commutateur et la quatrième inductance ;
les cinquièmes et sixièmes inductances étant agencées de sorte qu'un couplage électromagnétique puisse se créer entre la première inductance du deuxième commutateur et la cinquième inductance ainsi qu'entre la deuxième inductance du deuxième commutateur et la sixième inductance.

Un mode de réalisation prévoit un procédé de commande d'un composant à valeur contrôlable tel que décrit plus haut, comprenant un changement d'une valeur du composant à valeur variable par la commutation dudit au moins un transistor bipolaire dudit premier circuit de commutation (205).

Un mode de réalisation prévoit un procédé de commande d'un commutateur tel que décrit plus haut, comprenant la mise en court-circuit des premières et deuxièmes inductances par la commutation dudit au moins un transistor bipolaire dudit premier circuit de commutation.

Un mode de réalisation prévoit un procédé de commande d'un multiplexeur tel que décrit plus haut, comprenant la sélection d'un signal à transmettre par le changement d'état du signal de commande respectif d'au moins un parmi lesdits commutateurs.

Un mode de réalisation prévoit un circuit électrique comprenant au moins un transistor bipolaire dont une première électrode de conduction est couplée à au moins un premier composant électrique à commuter, et également à un potentiel électrique de référence par l'intermédiaire d'au moins un composant résistif ou inductif ou un transistor à effet de champ.

Selon un mode de réalisation, le transistor bipolaire est de type npn.

Selon un mode de réalisation, la première électrode de conduction correspond à l'émetteur du transistor bipolaire.

Selon un mode de réalisation, le circuit électrique comporte en outre une première résistance électrique dont une première électrode est couplée à une grille du transistor bipolaire et dont une deuxième électrode est configurée pour recevoir un premier signal de commande de commutation du circuit de commutation.

Selon un mode de réalisation, le composant résistif ou inductif correspond à une deuxième résistance électrique ou une inductance, et comporte une première électrode couplée à la première électrode de conduction du transistor bipolaire et une deuxième électrode couplée au potentiel électrique de référence.

Selon un mode de réalisation, la première électrode de conduction du transistor bipolaire est couplée à une première électrode de conduction du transistor à effet de champ, et dans lequel une deuxième électrode de conduction du transistor à effet de champ étant couplée au potentiel électrique de référence.

Selon un mode de réalisation, le transistor à effet de champ est de type N.

Selon un mode de réalisation, le circuit électrique comporte en outre une troisième résistance électrique dont une première électrode est couplée à une grille du transistor à effet de champ et dont une deuxième électrode est configurée pour recevoir un deuxième signal de commutation du circuit de commutation.

Selon un mode de réalisation, les premier et deuxième signaux de commutation du circuit de commutation correspondent à un même signal de commutation du circuit de commutation.

Selon un mode de réalisation, le premier composant électrique à commuter correspond à une capacité électrique ou une résistance électrique ou inductance ou un transistor.

Selon un mode de réalisation, le circuit électrique comprend en outre un deuxième composant électrique à commuter couplé à une deuxième électrode de conduction du transistor bipolaire.

Un mode de réalisation prévoit un procédé de commutation d'au moins un composant électrique à commuter, mis en œuvre à partir d'au moins un circuit électrique tel que décrit plus haut.

Un mode de réalisation prévoit un dispositif, un procédé ou un système, comportant une quelconque caractéristique décrite ou représentée, prise isolément ou en combinaison avec une autre.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A, 1B et 1C représentent schématiquement des exemples de capacités variables ;
les figures 2A et 2B représentent des exemples de circuits de la figure 1A selon des modes de réalisation ;
les figures 3A et 3B représentent des exemples de circuits de la figure 1A selon des modes de réalisation ;
les figures 4A et 4B représentent des graphes de variations de capacités en fonction de la fréquence ;
la figure 5 représente un exemple de multiplexeur selon un mode de réalisation ;
la figure 6A représente un exemple d'un circuit de commutation d'un multiplexeur selon un mode de réalisation ;
les figures 6B et 6C représentent des modes de fonctionnement de l'exemple de la figure 6A ;
les figures 7 et 8 représentent des exemples de circuits de commutation d'un multiplexeur selon des modes de réalisation ; et
la figure 9 représente un exemple de multiplexeur selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence, sauf précision contraire, à l'orientation des figures, dans une position normale d'utilisation.

Dans tous les modes de réalisation décrits, pour chaque transistor à effet de champ, les première et deuxième électrodes de conduction correspondent à deux électrodes différentes l'une de l'autre d'un même transistor, l'une d'elles correspondant à l'électrode de source et l'autre correspondant à l'électrode de drain. De même, pour chaque transistor bipolaire, les première et deuxième électrodes de conduction correspondent à deux électrodes différentes l'une de l'autre d'un même transistor, l'une d'elles correspondant à l'émetteur et l'autre correspondant au collecteur.

Sauf précision contraire, les expressions "environ", "approximativement", "sensiblement", et "de l'ordre de" signifient à 10 % près, de préférence à 5 % près.

La présente description s'applique notamment au domaine de la commutation radiofréquence (RF, ou « Radio Frequency » en anglais) ou haute fréquence, par exemple dans le domaine des GHz, et également au domaine des télécommunications et aux domaines suivants : ondes millimétriques (MMW, ou « Millimeter Wave » en anglais, 4G, 5G, 6G, bande Ku (« Kurz-unten »), bande Ka (« Kurz-above »), communications satellite en orbite terrestre basse (LEO, ou « Low Earth Orbit » en anglais), communications haut débit (ou « High data rates communications » en anglais), bande D et les bandes au-delà de la bande D.

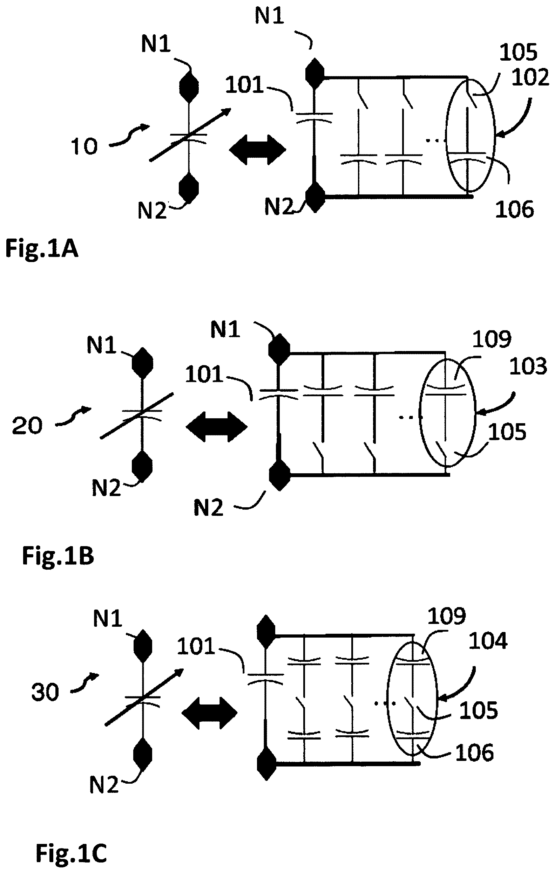

Les figures 1A à 5 sont relatives à un premier aspect qui porte sur les circuits de commutation et leur mise en œuvre par exemple dans des circuits à valeur configurable, ou dans des multiplexeurs.

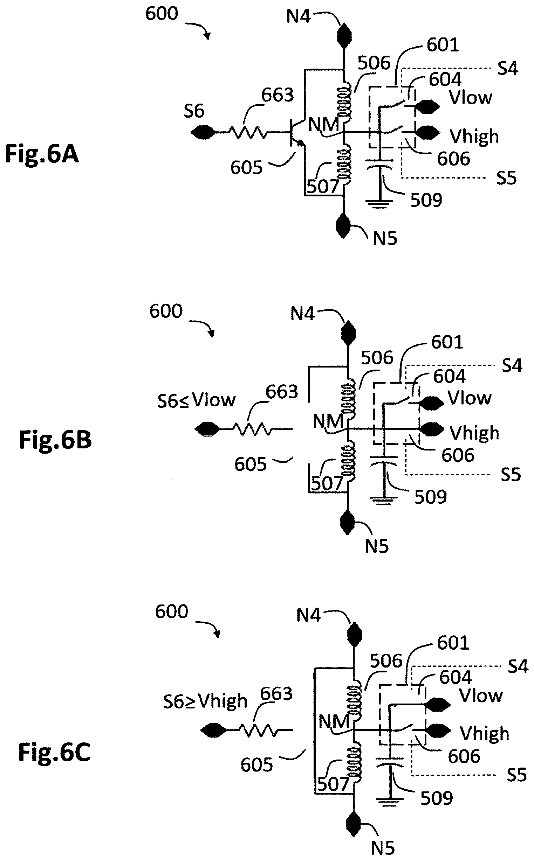

Les figures 6 à 9 sont relatives à un deuxième aspect portant sur les commutateurs et leur mise en œuvre au sein de multiplexeurs.

### Premier aspect

Les figures 1A, 1B et 1C représentent schématiquement des exemples de capacités variables auxquels peuvent s'appliquer les modes de réalisation.

Plus particulièrement, la figure 1A représente schématiquement, sur la partie gauche, une capacité variable 10 entre deux bornes N1 et N2, et sur la partie droite un exemple d'implémentation de cette capacité variable 10. La figure 1B représente schématiquement sur la partie gauche une capacité variable 20 entre les deux bornes N1 et N2, et sur la partie droite un exemple d'implémentation de cette capacité variable 20. La figure 1C représente schématiquement sur la partie gauche une capacité variable 30 entre les deux bornes N1 et N2, et sur la partie droite un exemple d'implémentation de cette capacité variable 30.

Dans l'exemple de la figure 1A, la capacité variable 10 est formée par une capacité 101 reliant les bornes N1 et N2, ainsi que par une pluralité de branches 102 similaires ou identiques, reliées en parallèle, et reliant chacune les bornes N1 et N2. Chacune des branches 102 comprend un interrupteur, ou commutateur, 105 en série avec une capacité 106. Une borne du commutateur 105 est reliée, préférentiellement connectée, à la borne N1, et une électrode de la capacité 106 est reliée, préférentiellement connectée, à la borne N2. Dans un exemple non illustré de la figure 1A, la capacité 101 est reliée au nœud N1 par l'intermédiaire d'un interrupteur.

Dans l'exemple de la figure 1B, la capacité variable 20 est formée par la capacité 101 reliant les bornes N1 et N2, ainsi que par une pluralité de branches 103 similaires ou identiques, reliées en parallèle, et reliant chacune les bornes N1 et N2. Chacune des branches 103 comprend l'interrupteur, ou commutateur, 105 en série avec une capacité 109. Une borne du commutateur 105 est cette fois reliée, préférentiellement connectée, à la borne N2, et une électrode de la capacité 109 est reliée, préférentiellement connectée, à la borne N1. Dans un exemple non illustré de la figure 1B, la capacité 101 est reliée au nœud N2 par l'intermédiaire d'un interrupteur.

Dans l'exemple de la figure 1C, la capacité variable 30 est formée par la capacité 101 reliant les bornes N1 et N2, ainsi que par une pluralité de branches 104 similaires ou identiques, reliées en parallèle, et reliant chacune les bornes N1 et N2. Chacune des branches 104 comprend la capacité 109 en série avec l'interrupteur, ou commutateur, 105 et la capacité 106. Une électrode de la capacité 109 est reliée, préférentiellement connectée, à la borne N1, et une autre électrode de la capacité 109 est reliée, préférentiellement connectée, à une borne du commutateur 105. Une électrode de la capacité 106 est reliée, préférentiellement connectée, à la borne N2, et une autre électrode de la capacité 106 est reliée, préférentiellement connectée, à une autre borne du commutateur 105. Dans un exemple non illustré de la figure 1C, la capacité 101 est remplacée par une branche similaire à une des branches 104.

Dans les exemples des figures 1A, 1B et 1C, les commutateurs 105 ont par exemple un comportement de type résistor. Dans un mode de conduction passant ou fermé, la résistance est proche de zéro, tandis que dans un mode de conduction non-passant ou ouvert, la résistance est haute par exemple au-dessus de plusieurs centaines d'Ohms.

Les exemples des figures 1A, 1B et 1C représentent des exemples de capacités variables ou configurables, il est cependant également possible d'obtenir d'autres types de composants à valeur variable, comme par exemple des résistances ou des inductances variables, en remplaçant les capacités 106 ou 109 par des résistances ou des inductances.

Il est en outre possible d'obtenir différents types de composants à valeur variable en utilisant des branches telles que les branches 102, 103, 104 en série, ou en augmentant le nombre de composants ou de commutateurs par branche.

Par les termes « valeur variable », on entend de façon équivalente, « valeur configurable » ou « caractéristique physique variable » ou « caractéristique physique configurable ».

Afin d'obtenir différents types de composants à valeur variable, il est également possible d'envisager d'avoir plusieurs composants similaires ou non en série, par exemple plusieurs résistances ou inductances en série, ou plusieurs commutateurs en série, ou une résistance et un commutateur en série, ou une inductance et un commutateur en série, et d'avoir des connexions au point milieu de ces composants ou commutateurs en série.

Les commutateurs 105 des exemples des figures 1A, 1B, 1C sont depuis de nombreuses années mis en œuvre à l'aide de transistors à effet de champ, comme des transistors NMOS ou PMOS. Néanmoins, pour qu'un transistor de type MOS puisse avoir une résistance à l'état passant qui soit la plus faible possible, il est nécessaire que sa taille soit assez élevée. Cela entraîne une augmentation de sa capacité parasite, qui en retour impacte négativement la réponse fréquentielle mais également le mode de conduction non-passant de par la création de courts-circuits en fonction de la fréquence.

Pour pallier à ces inconvénients, les modes de réalisation présentés prévoient que chaque commutateur 105 soit remplacé par un circuit de commutation comprenant au moins un transistor bipolaire configuré pour être couplé à au moins un composant électrique à commuter, le transistor bipolaire ayant une première électrode de conduction couplée à un potentiel électrique de référence par l'intermédiaire d'au moins un composant résistif ou inductif ou un autre transistor, par exemple à effet de champ ou bipolaire.

Dans la suite, le composant électrique à commuter est par exemple une résistance, ou une capacité, ou une inductance, ou encore plusieurs de ces composants agencés en série ou en parallèle. Pour la compréhension, l'élément à commuter correspond, dans les exemples des figures 1A à 1C, aux capacités 106 ou 109.

Dans la suite, les termes « élément à commuter » signifient que ledit élément peut être relié, ou déconnecté, par l'action du transistor bipolaire, à une autre partie de circuit.

L'utilisation de transistors bipolaires comporte un avantage supplémentaire sur les transistors MOS ou CMOS qui est que les différences de tensions de seuil, due aux dispersions lors de la fabrication, entre deux transistors à jonction bipolaire, sont beaucoup plus faible en comparaison de la dispersion des tensions de seuils de transistors MOS.

L'utilisation de transistors bipolaire permet la création d'une résistance forte à l'état non-passant ainsi qu'une résistance faible à l'état passant, tout en utilisant une empreinte plus faible.

Remplacer un transistor de type MOS ou à effet de champ, par un transistor bipolaire n'est cependant pas direct ou évident puisque les transistors bipolaires fonctionnent avec un courant contrairement aux transistors MOS. Ainsi, en remplaçant simplement un transistor MOS par un transistor bipolaire, le transistor bipolaire ne fonctionnerait pas de façon optimale, voir ne fonctionnerait pas du tout. Les modes de réalisations proposent ainsi de créer un chemin de tension, ou de courant continu (DC path, DC connection, en anglais), entre une électrode du transistor bipolaire, par exemple entre la base et/ou l'émetteur et une tension de référence comme la masse par exemple. Ce chemin de tension ou courant continu est réalisé en reliant une électrode de conduction du transistor bipolaire à un potentiel électrique de référence, comme par exemple la masse, par l'intermédiaire d'au moins un composant résistif, comme une résistance, ou inductif comme une inductance, ou un transistor, par exemple un transistor à effet de champ, ou un autre transistor bipolaire.

Dans le mode de conduction passant ou fermé, le courant passe à travers l'électrode, par exemple l'émetteur, du transistor bipolaire reliée au potentiel de référence en direction de ce potentiel de référence. La tension base-émetteur créée permet ainsi de rendre le transistor passant et la résistance du transistor est faible. La résistance du composant résistif est prévue pour être suffisamment élevée pour qu'il ne soit pas majoritairement emprunté dans l'état passant du transistor bipolaire.

Dans le mode non-passant ou ouvert, le transistor bipolaire est ouvert et présente une impédance équivalente, et puisque la résistance de l'élément résistif est élevée, l'impédance à la connexion avec le composant à commuter est élevée. Cela permet que la capacité liée au transistor bipolaire ne soit pas vue dans le mode non-passant.

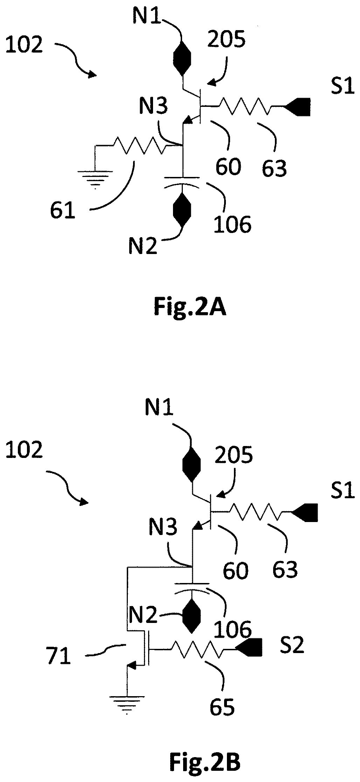

Les figures 2A et 2B représentent des exemples de circuits de la figure 1A selon des modes de réalisation. Plus particulièrement, les exemples représentés illustrent des modes de réalisation de branches 102 où le commutateur 105 est remplacé par un circuit de commutation 205.

Dans l'exemple représenté, le circuit de commutation 205 comprend un transistor bipolaire 60 dont le collecteur est relié, préférentiellement connecté, à la borne N1, et dont l'émetteur N3 est relié à la masse par l'intermédiaire d'une résistance 61. La capacité 106 relie l'émetteur N3 du transistor bipolaire à la borne N2. Une résistance 63 facultative relie la base du transistor bipolaire 60 à un rail d'application d'un signal de commande S1.

La résistance 61 a une valeur qui peut être choisie par la personne du métier entre quelques Ohms et plusieurs centaines d'Ohms.

La résistance 63 a une valeur qui peut être choisie par la personne du métier entre quelques Ohms et plusieurs centaines d'Ohms.

Dans l'exemple de la figure 2A, le chemin continu est obtenu par la connexion de l'émetteur avec la résistance 61 et sa connexion à la masse.

L'exemple de la figure 2B est similaire à celui de la figure 2B sauf que la résistance 61 est remplacée par un transistor 71 dont un nœud, ou électrode, de conduction est relié, préférentiellement connecté, à l'émetteur du transistor bipolaire 60, et un autre nœud de conduction est relié, préférentiellement connecté, à la masse. Une résistance facultative 65 relie un nœud, ou électrode, de commande du transistor 71 à un rail d'application d'un signal de commande S2. Les signaux de commande S1 et S2 sont par exemple les mêmes ou ils peuvent être différents, ou bien ce sont deux signaux simultanés.

Le transistor 71 est par exemple un transistor à effet de champ, par exemple NMOS ou PMOS, ou un transistor bipolaire.

Dans un mode de conduction passant du circuit de commutation 205, le transistor bipolaire 60 est commandé par le signal S1 pour être passant, le transistor 71 est également commandé par le signal S2 pour être dans un état passant ce qui permet d'obtenir une résistance équivalente reliant l'émetteur du transistor bipolaire et la masse.

Dans un mode de conduction non-passant du circuit de commutation 205, le transistor bipolaire 60 est commandé par le signal S1 pour être non-passant, et le transistor 71 est également commandé par le signal S2 pour être non-passant. Le transistor 71 présente alors une résistance élevée.

L'exemple de la figure 2B permet d'obtenir une résistance à l'état passant qui est plus faible que la résistance 61 de l'exemple de la figure 2A et une résistance à l'état non-passant qui est plus élevée que la résistance 61 de l'exemple de la figure 2A. Cela permet d'assurer un facteur de qualité plus élevé et d'assurer moins de pertes.

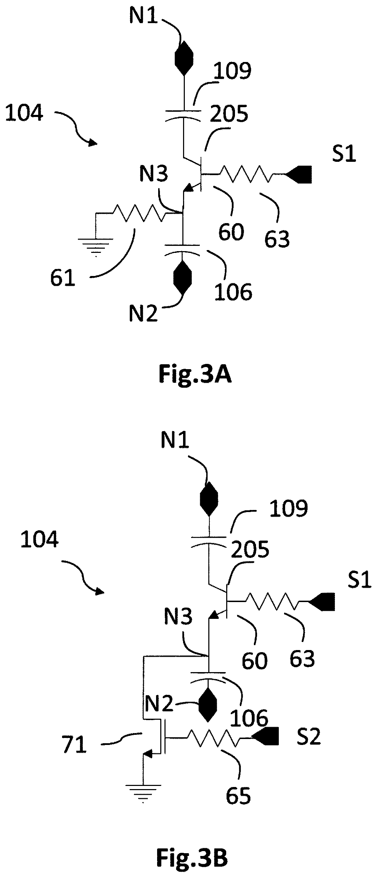

Les figures 3A et 3B représentent des exemples de circuits de la figure 1A selon des modes de réalisation. Plus particulièrement, les exemples représentés illustrent des modes de réalisation des branches 104 où le commutateur 105 est remplacé par un circuit de commutation 205.

Les exemples des figures 3A et 3B sont similaires respectivement aux exemples des figures 2A et 2B sauf que la capacité 109 relie le collecteur du transistor bipolaire 60 à la borne N1.

Même si les figures 2A, 2B, 3A, et 3B, illustrent des exemples de capacité configurable, la personne du métier pourra mettre en œuvre une ou plusieurs inductances en lieu et place de la résistance 61 ou du transistor 71.

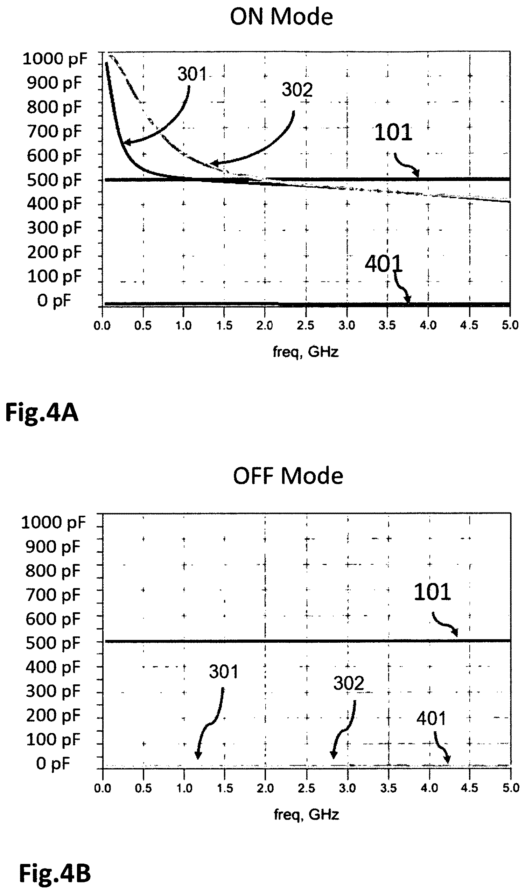

Les figures 4A et 4B représentent des graphes de variations de capacités en fonction de la fréquence, respectivement dans un mode de conduction passant (ON Mode) et dans un mode de conduction non-passant (OFF Mode) du circuit de commutation 205. Plus précisément, la figure 4A représente les capacités respective 301, 302 du circuit de la figure 3A et du circuit la figure 3B en fonction de la fréquence, ainsi que le comportement fréquentiel de la capacité 101 seule, et enfin le comportement fréquentiel de la capacité équivalente 401 du circuit de la figures 3A ou 3B mais où la résistance 61 ou le transistor 71 sont absents pour relier l'émetteur du transistor bipolaire du circuit 205 à la masse. A titre d'exemple, les capacités utilisées pour obtenir ces graphes sont de 1 pF pour les capacités 106 et 109, la résistance 61 est de 1 kOhm et la résistance 63 est de 1 kOhm.

Sur le graphe de la figure 4A, la capacité 301 baisse rapidement entre 1000 pF et la valeur de la capacité 101, i.e. 500 pF, entre 0,1 GHz et 1 GHz. Au-delà d'1 GHz, la capacité 301 diminue légèrement et linéairement jusqu'à une valeur de 400 pF à 5 GHz.

Dans le graphe de la figure 4A, la capacité 302 baisse rapidement entre 1000 pF et la valeur de la capacité 101 entre 0,1 GHz et 2 GHz. Cette baisse est néanmoins moins rapide que pour la capacité 301. Au-delà de 2 GHz, la capacité 302 se comporte comme la capacité 301 et diminue légèrement et linéairement jusqu'à une valeur de 400 pF à 5 GHz.

Dans l'exemple de la figure 4A, la capacité 101 reste stable entre 0,1 et 5 GHz avec une valeur de 500 pF.

Dans cet exemple, la capacité équivalente 401 reste à zéro quelque soit la fréquence, cela montre que sans l'ajout d'un chemin continu entre l'émetteur du transistor bipolaire du circuit de commutation 205 et la masse, alors le transistor bipolaire seul ne fonctionne pas.

Il résulte de l'exemple de la figure 4B, que dans le mode de conduction non-passant (OFF mode), les capacités 301 et 302 restent très faibles voir à zéro ce qui permet d'améliorer les performances en haute fréquence. La capacité 401 reste équivalente à celle de l'exemple du graphe 4A ce qui montre que le bipolaire seul ne peut fonctionner en remplacement d'un transistor MOS par exemple. La capacité 101 reste, elle, stable.

Il est ainsi démontré qu'il est possible d'obtenir un composant à valeur configurable, et capable de fonctionner à haute fréquence de l'ordre de plusieurs GHz, en utilisant des circuits de commutation à base de transistors bipolaires en créant un chemin de courant ou de tension continu entre par exemple l'émetteur et la masse, c'est-à-dire entre la base et l'émetteur (tension base émetteur > 0 V).

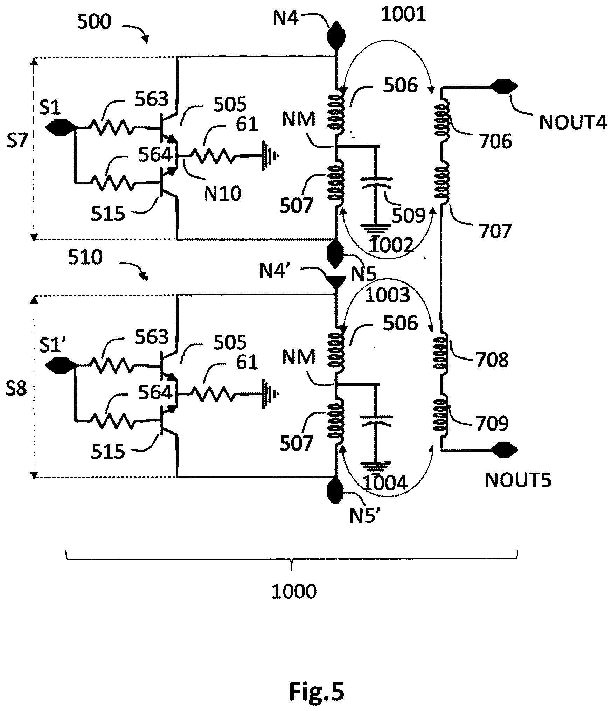

La figure 5 représente un exemple de multiplexeur 1000, par exemple radiofréquence, selon un mode de réalisation.

Les multiplexeurs permettent de sélectionner, en fonction d'un ou plusieurs signaux de commande, une voie ou un signal à transmettre en sortie parmi plusieurs voies ou signaux entrants.

Le multiplexeur 1000 de la figure 5 comprend un premier et un deuxième commutateurs 500, 510 qui sont similaires ou identiques.

Dans l'exemple représenté, le premier commutateur 500 comprend un transistor bipolaire 505 reliant un nœud N4 d'application ou de réception d'un signal différentiel S7 et un nœud N10. Un élément résistif, ici illustré par une résistance, par exemple similaire ou identique à la résistance 61, relie le nœud N10 à la masse. Dans l'exemple illustré, l'émetteur du transistor 505 est relié, préférentiellement connecté, au nœud N10 de sorte à créer un chemin de tension ou de courant continu comme vu dans les figures 2A, 2B, 3A, 3B. Le premier commutateur 500 comporte en outre une résistance électrique 563 dont une première borne est couplée à une base du transistor bipolaire 505 et dont une deuxième borne est configurée pour être reliée à un rail d'application d'un signal de commande, par exemple similaire au signal S1.

Le premier commutateur 500 comprend en outre, de façon facultative, un autre transistor bipolaire 515 reliant le nœud N10 à un autre nœud N5 d'application ou de réception du signal différentiel S7. Dans l'exemple illustré, l'émetteur du transistor 515 est relié, préférentiellement connecté, au nœud N10. Une résistance électrique 564, par exemple similaire à la résistance 563, comprend une première borne couplée à une base du transistor bipolaire 515 et une deuxième borne reliée au nœud d'application du signal de commande S1.

L'élément résistif 61 permet d'obtenir une tension base-émetteur Vbe :
- basse dans les transistors 505 et 515 lorsque le signal S1 est bas pour permettre de rendre non-passant ces transistors 505, 515, et ;
- haute lorsque le signal S1 est à l'état haut, pour permettre de rendre passant les transistors 505, 515.

Dans l'exemple illustré, le premier commutateur 500 comprend en outre deux inductances 506 et 507 en série entre le nœud N4 et le nœud N5. Une capacité 509 de découplage, facultative, relie un point milieu NM des inductances 506, 507 à la masse. Les inductances 506, 507 peuvent être vues comme étant deux parties d'une même inductance.

Le fait d'avoir deux transistors bipolaires 505 et 515 agencés tels que présenté dans l'exemple de la figure 5 permet de court-circuiter les deux inductances 506 et 507 de façon similaire lorsque les transistors bipolaires 505, 515 sont passants.

Le deuxième commutateur 510 est par exemple similaire ou identique au commutateur 500 sauf qu'à la place du signal de commande S1, il reçoit un autre signal S1' qui peut être par exemple opposé ou complémentaire au signal S1. Le deuxième commutateur 510 se voit appliquer ou reçoit un signal différentiel S8, par exemple différent du signal S7, entre des nœuds N4' et N5' qui correspondent au nœuds N4 et N5 du premier commutateur 500 mais appliqués au deuxième commutateur 510.

Dans un mode d'émission, les signaux S7 et S8 correspondent par exemple à des signaux appliqués respectivement aux nœuds N4, N5 et N5, N5' pour être sélectionnés et que l'un d'entre eux se retrouve à la sortie du multiplexeur. Dans un mode de transmission ou d'émission, un signal arrivant sur la sortie du multiplexeur peut être distribué sur l'un ou l'autre des commutateurs 500, 510, au niveau des nœuds N4, N5 ou N4', N5' en fonction de la sélection effectuée.

Dans l'exemple illustré, le multiplexeur 1000 comprend en outre quatre inductances en série 706, 707, 708, 709, entre les nœuds de sortie NOUT4 et NOUT5. Les inductances 706, 707 sont par exemple agencées de sorte qu'un couplage électromagnétique 1001 puisse se créer entre l'inductance 506 du premier commutateur 500 et l'inductance 706, et qu'un couple électromagnétique 1002 puisse se créer entre l'inductance 507 du premier commutateur 500 et l'inductance 707. Les inductances 708, 709 sont agencées de sorte qu'un couplage électromagnétique 1003 puisse se créer entre l'inductance 506 du deuxième commutateur 510 et l'inductance 708, et qu'un couplage électromagnétique 1004 puisse se créer entre la deuxième inductance 507 du deuxième commutateur 510 et l'inductance 709.

Les commutateurs 500, 510 forment des canaux différents qui sont sélectionnables, autant en émission qu'en réception, par l'état des signaux S1 et S1'.

Les inductances 506, 507 de chacun des commutateurs 500, 510 forment l'étage primaire d'un transformateur de type BALUN (balanced/unbalanced en anglais, équilibré, déséquilibré en français). Les inductances 706, 707 et 708, 709 constituent l'étage secondaire de ce transformateur.

En fonction de l'état des signaux S1 et S1', les commutateurs 500 et 510 sont passant ou non-passant. Par exemple, lorsque le signal S1 est à l'état haut et que le signal S1' est à l'état bas, les inductances 506 et 507 du premier commutateur 500 sont court-circuitées puisque les transistors bipolaires 505 et 515 sont passant, cela implique que les inductances 506 et 507 sont alors en court-circuit et ainsi équivalentes à une inductance de très faible valeur. Comme les couplages 1001 et 1002 relient les inductances 506 à 706 et 507 à 707, alors, de fait, les inductances 706 et 707 deviennent très faibles. La partie haute de cet exemple de multiplexeur est équivalente à un court-circuit. Au contraire, les transistors bipolaires 505 et 515 du deuxième commutateur 510 sont alors non-passants ce qui fait que le signal différentiel S8 peut se propager, via les couplages électromagnétiques 1003 et 1004 sur les nœuds de sortie NOUT4 et NOUT5. A l'inverse, lorsque le signal S1 est à l'état bas et que le signal S1' est à l'état haut, les inductances 506 et 507 du deuxième commutateur 510 sont court-circuitées, cela implique que les inductances 506 et 507 sont alors en court-circuit et ainsi équivalentes à une inductance de très faible valeur. Comme les couplages 1003 et 1004 relient les inductances 506 à 708 et 507 à 709, alors de fait les inductances 708 et 709 deviennent très faibles. La partie basse de cet exemple de multiplexeur est équivalente à un court-circuit. Au contraire, les transistors bipolaires 505 et 515 du premier commutateur 500 sont alors non-passants ce qui fait que le signal différentiel S7 peut se propager, via les couplages électromagnétiques 1001 et 1002 sur les nœuds de sortie NOUT4 et NOUT5.

L'exemple de la figure 5 permet donc de réaliser un multiplexeur à base de transistors bipolaires où, en fonction de l'état des signaux S1 et S1', et en mode d'émission, l'un des signaux S7 ou S8 est sélectionné pour se retrouver sur les nœuds de sortie NOUT4 et NOUT5.

Autrement dit, le multiplexeur 1000 de la figure 5 permet, dans un mode d'émission (TX), de choisir un signal parmi les signaux différentiels S7 et S8 appliqués sur les nœuds N4, N5, N4', N5', respectifs, pour que le signal sélectionné se retrouve en sortie entre les nœuds NOUT4 et NOUT5 du multiplexeur.

A l'inverse, dans un mode de réception (RX), le multiplexeur 1000 permet de choisir vers quel canal, c'est-à-dire vers quels nœuds N4, N5 ou N4', N5', va être dirigé un signal entrant présent sur les nœuds NOUT4 et NOUT5.

### Deuxième aspect

Le deuxième aspect porte sur des commutateurs à base de transistors bipolaires et des multiplexeurs mis en œuvre à l'aide de ces multiplexeurs.

La figure 6A représente un exemple d'un commutateur 600, autrement appelé circuit de commutation, par exemple pour multiplexeurs, selon un mode de réalisation.

Dans l'exemple de la figure 6A, le commutateur 600 comprend un transistor bipolaire 605 dont :
le collecteur est relié, préférentiellement connecté, à un nœud N4 d'application ou de réception d'un signal par exemple différentiel, et par exemple similaire au nœud N4 de la figure 5 ; et
l'émetteur est relié, préférentiellement connecté, à un nœud N5 d'application ou de réception d'un signal par exemple différentiel, et par exemple similaire ou identique au nœud N5 de la figure 5.

La base du transistor bipolaire 605 est reliée à un rail d'application d'un signal de commande S6, par l'intermédiaire d'une résistance 663.

Dans l'exemple illustré, le commutateur 600 comprend deux inductances en série 506, 507, par exemple similaires aux inductances 506, 507 de la figure 5, entre le nœud N4 et le nœud N5. Une capacité 509 de découplage, facultative et par exemple similaire ou identique à la capacité 509 de la figure 5, relie le point milieu NM des inductances 506, 507, à la masse.

Dans l'exemple de la figure 6A, le commutateur 600 comprend en outre un circuit de sélection 601, configuré pour relier, de façon commandable, le point milieu NM des inductances, soit à un rail d'application d'une tension Vlow via un interrupteur 604, soit à un rail d'application d'une tension Vhigh via un interrupteur 606. Dans un exemple, la tension Vlow est inférieure à Vhigh. Par exemple, la tension Vlow est égale ou inférieure à 0 V, et la tension Vhigh est supérieure ou égale à une tension de seuil de déclenchement, typiquement au-dessus de 0,6V, jusqu'à plusieurs volts. Les interrupteurs 604 et 606 ont leur mode de conduction passant ou non-passant respectivement commandé par l'état d'un signal S4 et d'un signal S5.

Dans un exemple, les interrupteurs 604, 606 sont des transistors par exemple de type MOS ou bipolaires.

Les figures 6B et 6C représentent des modes de fonctionnement de l'exemple de la figure 6A.

Dans l'exemple de la figure 6B, le signal S5 rend passant l'interrupteur 606, le signal S4 laisse l'interrupteur 604 non-passant, la tension Vhigh se retrouve ainsi sur le point milieu des inductances 506 et 507, et se retrouve ensuite aux nœuds N4 et N5. Lorsqu'une tension du signal S6 est égale, ou similaire, ou inférieure, à la tension Vlow, et que la tension Vhigh se retrouve, par l'action de l'interrupteur 606, sur les nœuds N4 et N5, alors le transistor bipolaire 605 devient non-passant ou ouvert car la tension Vbe n'est pas positive ou alors nulle et donc un chemin de courant n'est pas créé.

Dans la figure 6C, le signal S4 rend passant l'interrupteur 604, et le signal S5 laisse l'interrupteur 606 non-passant, la tension Vlow se retrouve alors sur le point milieu des inductances 506 et 507, et se retrouve ensuite aux nœuds N4 et N5. Lorsqu'une tension du signal S6 est égale, ou similaire, ou supérieure, à la tension Vhigh, et que la tension Vlow se retrouve, par l'action de l'interrupteur 604, sur les nœuds N4 et N5, alors le transistor bipolaire 605 devient conducteur et le les inductances 506, 507 sont ainsi court-circuitées.

Le circuit de sélection 601 permet ainsi, en fonction du signal de commande S6, de définir l'état de conduction du transistor bipolaire 605.

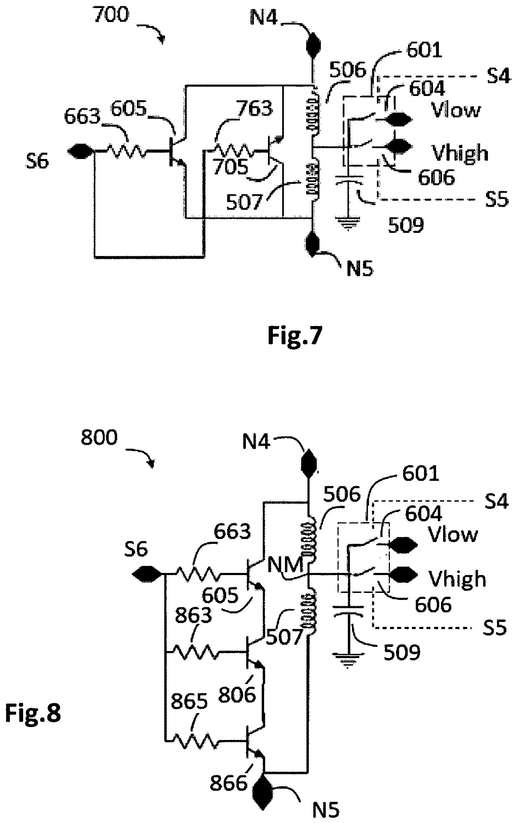

Les figures 7 et 8 représentent des exemples de commutateur 700, par exemple pour multiplexeurs, selon des modes de réalisation.

Le commutateur 700 est similaire au commutateur 600 de la figure 6A sauf qu'il comprend un transistor bipolaire 705 additionnel reliant le nœud N4 et le nœud N5. Le collecteur du transistor 705 est relié, préférentiellement connecté, au nœud N5, et l'émetteur du transistor 705 est relié, préférentiellement connecté, au nœud N4. Une résistance 763 relie la base du transistor 705 au rail d'application du signal S6.

Le commutateur 800 est similaire au commutateur 600 de la figure 6A sauf qu'il comprend plusieurs, par exemple deux, transistors bipolaires 806, 866 additionnels en série avec le transistor 605. Le transistor bipolaire 806 a son collecteur relié, préférentiellement connecté, à l'émetteur du transistor bipolaire 605, et son émetteur relié, préférentiellement connecté, au collecteur du transistor 866. L'émetteur du transistor 866 est relié, préférentiellement connecté, au nœud N5. Une résistance 863 relie la base du transistor 806 au rail d'application du signal S6. Une résistance 865 relie la base du transistor 866 au rail d'application du signal S6.

L'exemple de la figure 7 permet d'améliorer la symétrie par l'emploi des deux transistors 605, 705 en miroir.

L'exemple de la figure 8 permet de soutenir une amplitude de tension supérieure grâce à l'emploi de plusieurs transistors bipolaires en parallèle.

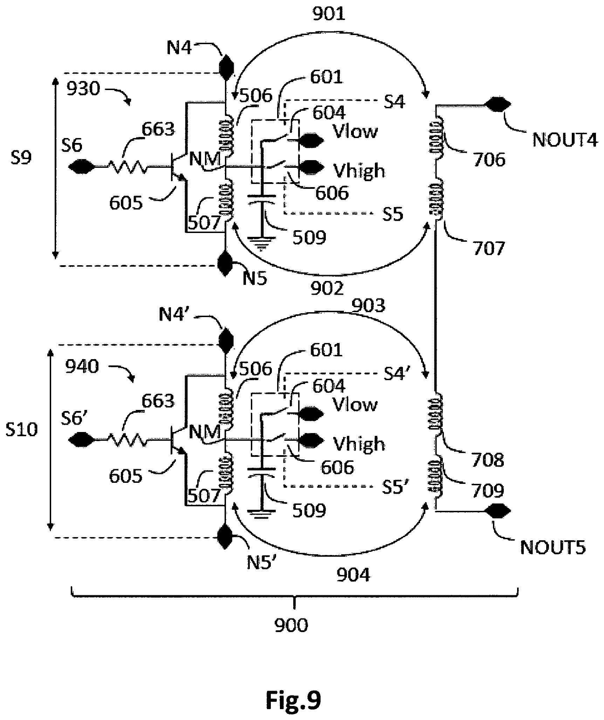

La figure 9 représente un exemple de multiplexeur 900 selon un mode de réalisation.

Le multiplexeur 900 de la figure 9 permet de sélectionner un signal parmi des signaux différentiels S9 et S10, pour que dans un mode d'émission, le signal sélectionné se retrouve en sortie entre des nœuds NOUT4 et NOUT5 du multiplexeur.

Le multiplexeur 900 de la figure 9 comprend deux commutateurs 930, 940 qui sont similaires ou identiques au commutateur 600 de la figure 6A.

Le commutateur 930 reçoit un signal de commande, autrement dit un signal de commutation S6 par exemple similaire au signal S6 de la figure 6A. Le commutateur 930 est configuré de sorte que le signal différentiel S9 soit appliqué entre les nœuds N4 et N5 en mode d'émission, ou qu'il soit reçu entre ces nœuds N4, N5 en mode de réception.

Le commutateur 940 est par exemple similaire ou identique au commutateur 930 sauf qu'à la place du signal de commande S6, il reçoit un autre signal de commande qui peut être par exemple opposé ou complémentaire au signal S6, et qui reçoit le signal différentiel S10, par exemple différent du signal S9, entre des nœuds N4' et N5'. Les nœuds N4' et N5' correspondent aux nœuds N4 et N5 du commutateur 600 de la figure 6A mais appliqués au commutateur 940.

Dans l'exemple illustré, le multiplexeur 900 comprend en outre quatre inductances en série 706, 707, 708, 709, entre les nœuds de sortie NOUT4 et NOUT5. Les inductances 706, 707 sont par exemple agencées de sorte qu'un couplage électromagnétique 901 puisse se créer entre l'inductance 506 du commutateur 930 et l'inductance 706, et qu'un couplage électromagnétique 902 puisse se créer entre l'inductance 507 du commutateur 930 et l'inductance 707. Les inductances 708, 709 sont agencées de sorte qu'un couplage électromagnétique 903 puisse se créer entre l'inductance 506 du commutateur 940 et l'inductance 708, et qu'un couplage électromagnétique 904 puisse se créer entre la deuxième inductance 507 du commutateur 940 et l'inductance 709.

Les inductances 506, 507 de chacun des commutateurs 500, 510 forment l'étage primaire d'un transformateur de type BALUN. Les inductances 706, 707 et 708, 709 constituent l'étage secondaire de ces transformateurs.

En fonction de l'état des signaux S6 et S6', et de l'état des interrupteurs 604, 606, les transistors respectifs 605 de chacun des commutateurs 930 et 940 sont passant ou non-passant. Par exemple, lorsque le signal S6 est à l'état haut i.e. égal ou supérieur à Vhigh, alors que l'interrupteur 604 du commutateur 930 est passant, et que le signal S6' est à l'état bas, c'est-à-dire égal ou inférieur à Vlow, alors que l'interrupteur 606 du commutateur 940 est passant, les inductances 506 et 507 du commutateur 930 sont court-circuitées et les inductances 506 et 507 du commutateur 940 ne sont pas court-circuitées. Cela implique que les inductances 706 et 707 se retrouvent elles aussi court-circuitées avec le couplage 901 et 902 aux inductances 506 et 507. Le signal différentiel S10 peut alors se propager, via les couplages électromagnétiques 903 et 904 sur les nœuds de sortie NOUT4 et NOUT5.

Au contraire, lorsque le signal S6 est à l'état bas alors que l'interrupteur 606 du commutateur 930 est passant, et que le signal S6' est à l'état haut alors que l'interrupteur 604 du commutateur 940 est passant, alors les inductances 506 et 507 du commutateur 940 sont court-circuitées. les inductances 708 et 709 se retrouvent elles aussi court-circuitées avec le couplage 903 et 904 aux inductances 506 et 507. Le signal différentiel S9 peut alors se propager, via les couplages électromagnétiques 901 et 902 sur les nœuds de sortie NOUT4 et NOUT5.

L'exemple de la figure 9 permet donc de réaliser un multiplexeur à base de transistors bipolaires où, en fonction de l'état des signaux S6 et S6' et en fonction de l'état des interrupteurs 604, 606 de chacun des commutateurs, dans un mode d'émission, l'un des signaux S9 ou S10 est sélectionné pour se retrouver sur les nœuds de sortie NOUT4 et NOUT5, et dans un mode de réception, un des commutateurs 930, 940 est sélectionné pour recevoir sur ces nœuds N4, N5 ou N4', N5' le signal présent sur les nœuds NOUT4, NOUT5.

Autrement dit, le multiplexeur 900 de la figure 9 permet, dans un mode d'émission (TX), de choisir un signal parmi les signaux différentiels S9 et S10 appliqués sur les nœuds N4, N5, N4', N5', respectifs, pour que le signal sélectionné se retrouve en sortie entre les nœuds NOUT4 et NOUT5 du multiplexeur.

A l'inverse, dans un mode de réception (RX), le multiplexeur 900 permet de choisir vers quel canal, c'est-à-dire vers quels nœuds N4, N5 ou N4', N5', va être dirigé un signal présent sur les nœuds NOUT4 et NOUT5.

L'exemple de la figure 9 permet, en mode de réception, d'obtenir par exemple des pertes d'insertion faibles de l'ordre de 2,5 dB pour des fréquences entre 12 et 14,25 GHz alors que l'impédance est haute, par exemple autour de 100,2 Ohms, du côté de l'émission et faible, par exemple autour de 2,6 Ohms, du côté de la réception.

L'exemple de la figure 9 permet, en mode d'émission, d'obtenir par exemple des pertes d'insertion faibles de l'ordre de 2,5 dB pour des fréquences entre 12 et 14,25 GHz alors que l'impédance est haute, par exemple autour de 100,6 Ohms, du côté de l'émission et faible, par exemple autour de 2,6 Ohms, du côté de la réception.

Tous les exemples précédents ont été décrits avec des commutateurs utilisés pour coupler entre elles des capacités. En variante, ces exemples peuvent s'appliquer pour coupler, en alternative ou en combinaison, des inductances, des capacités, des résistances électriques, des transistors, ou d'autres types de composants.

Dans les différents exemples décrits, les transistors bipolaires sont de type NPN. En variante, les transistors bipolaires peuvent être de type PNP.

Dans les différents exemples décrits, les transistors à effet de champ sont de type N. En variante, les transistors à effet peuvent être de type P.

Les différents exemples de réalisation permettent de réaliser des commutateurs RF moins coûteux que ceux basés sur des technologies MOS.

Dans les différents exemples de réalisation, les commutateurs peuvent être réalisés en technologie bipolaire.

Dans les différents exemples de réalisation, on peut réaliser une faible surface commandée par une faible surface bipolaire, sans coût additionnel.

Il est proposé un circuit permettant de réduire la surface occupée par les composants RF tout en maintenant une commutation dans des fréquences de fonctionnement telles que la bande Ka ou Ku.

Les exemples de modes de réalisation qui suivent concernent le deuxième aspect.

Exemple 1 : Commutateur 600, 700, 800, 930, 940, par exemple radiofréquence, comprenant :
- au moins un premier transistor bipolaire 605 reliant un premier nœud N4 d'application ou de réception d'un signal différentiel S7, S8, S9, S10 et un deuxième nœud N5 d'application ou de réception du signal différentiel S7, S8, S9, S10;
- une première et une deuxième inductances 506, 507 en série entre le premier nœud N4 et le deuxième nœud N5;
- un circuit de sélection 601, configuré pour relier, de façon commandable, un point milieu NM des premières et deuxièmes inductances 506, 507, soit à un rail d'application d'une première tension Vlow, soit à un rail d'application d'une deuxième tension Vhigh.

Exemple 2 : Commutateur 600, 700, 800, 930, 940 selon l'exemple 1, dans lequel une capacité 109 relie le point milieu des premières et deuxièmes inductances 106, 107 à la masse.

Exemple 3 : Commutateur 600, 700, 800, 930, 940 selon l'exemple 1 ou 2, dans lequel le commutateur 600, 700, 800, 930, 940 comporte en outre une première résistance électrique 663 dont une première borne est couplée à une base du premier transistor bipolaire 605 et dont une deuxième borne est reliée à un rail d'application d'un premier signal de commande S6, S6'.

Exemple 4 : Commutateur 700 selon l'un quelconque des exemples 1 à 3, dans lequel le commutateur 700 comporte un deuxième transistor bipolaire 705 reliant le premier nœud N4, N4' et le deuxième nœud N5, N5' ;
un émetteur du premier transistor bipolaire étant relié à un collecteur du deuxième transistor bipolaire, et un émetteur du deuxième transistor bipolaire étant relié à un collecteur du premier transistor bipolaire.

Exemple 5 : Commutateur 700 selon les exemples 3 et 4, dans lequel le commutateur 700 comporte en outre une deuxième résistance électrique 763 dont une première borne est couplée à une base du deuxième transistor bipolaire et dont une deuxième borne est reliée audit rail d'application du premier signal de commande S6.

Exemple 6 : Commutateur selon l'un quelconque des exemples 1 à 3, dans lequel le premier transistor bipolaire 605 relie le premier nœud N4, N4' et le deuxième nœud N5, N5' par l'intermédiaire d'un ou plusieurs troisièmes transistors 806, 866 bipolaires reliés en série entre le premier transistor bipolaire 605 et le deuxième nœud N5, N5'.

Exemple 7 : Commutateur selon l'exemple 6, dans lequel la base de chacun desdits un ou plusieurs troisièmes transistors 806, 866 est reliée à une première borne d'une troisième résistance 863, 865 respective, chacune des dites troisièmes résistances ayant une deuxième borne reliée audit rail d'application du premier signal de commande S6, S6'.

Exemple 8 : Commutateur selon l'exemple 6 ou 7, dans lequel l'émetteur d'au moins un parmi lesdits troisièmes transistors est relié au collecteur du troisième transistor suivant de la série.

Exemple 9 : Commutateur selon l'un quelconque des exemples 1 à 8, dans lequel le circuit de sélection 601 comprend :
- un premier interrupteur 604 reliant le point milieu NM des premières et deuxièmes inductances 506, 507 au rail d'application de la première tension Vlow ; et/ou
- un deuxième interrupteur 606 reliant le point milieu NM des premières et deuxièmes inductances 506, 507 au rail d'application de la deuxième tension Vhigh.

Exemple 10 : Commutateur selon l'un quelconque des exemples 1 à 9, dans lequel la première tension Vlow est inférieure à la deuxième tension Vhigh.

Exemple 11 : Commutateur selon l'exemple 9 dans sa dépendance à l'exemple 3, ou l'exemple 10 dans sa dépendance à l'exemple 9 et à l'exemple 3, dans lequel pour que le commutateur soit dans un premier état où les premières et deuxièmes inductances 506, 507 sont court-circuitées, une tension du premier signal de commande S6 est égale, ou similaire, ou supérieure, à la deuxième tension Vhigh, et le premier interrupteur est commandé pour être passant.

Exemple 12 : Commutateur selon l'exemple 9 dans sa dépendance à l'exemple 3, ou selon l'exemple 10 ou 11, dans lequel, pour que le commutateur soit dans un deuxième état où le premier transistor 605 est non-passant, une tension du premier signal de commande S6 est égale, ou similaire, ou inférieure, à la première tension Vlow, et le deuxième interrupteur 606 est commandé pour être passant.

Exemple 13 : Multiplexeur comprenant :
- un premier commutateur 600, 700, 800, 930, selon l'un quelconque des exemples 1 à 12 ;
- un deuxième commutateur 600, 700, 800, 940 selon l'un quelconque des exemples 1 à 12 ;
- des troisièmes, quatrièmes, cinquièmes et sixièmes inductances en série 706, 707, 708, 709 ;

les troisièmes et quatrièmes inductances 706, 707 étant agencées de sorte qu'un couplage électromagnétique 901, 902 puisse se créer respectivement entre la première inductance 506 du premier commutateur et la troisième inductance 706 ainsi qu'entre la deuxième inductance 507 du premier commutateur et la quatrième inductance 707 ;
les cinquièmes et sixièmes inductances 708, 709 étant agencées de sorte qu'un couplage électromagnétique 903, 904 puisse se créer entre la première inductance 506 du deuxième commutateur et la cinquième inductance 507 ainsi qu'entre la deuxième inductance 507 du deuxième commutateur et la sixième inductance 709.

Exemple 14 : Multiplexeur selon l'exemple 13, dans lequel :
- les premiers et deuxièmes nœuds N4, N5, du premier commutateur 600, 700, 800, 930 sont configurés pour qu'un premier signal différentiel S7, S9 y soit appliqué ou y soit reçu ; et
- les premiers et deuxièmes nœuds N4', N5', du deuxième commutateur 600, 700, 800, 940 sont configurés pour recevoir un deuxième signal différentiel S8, S10 différent du premier signal différentiel S7, S9.

Exemple 15 : Multiplexeur selon les exemples 13 et 14 dans leur dépendance aux exemples 10 à 13, dans lequel un niveau du premier signal de commande S6 du premier commutateur, et un niveau du premier signal de commande S6' du deuxième commutateur, sont opposés ou complémentaires.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, en ce qui concerne les multiplexeurs 900 et 1000 des figures 9 et 5, bien que décrits pour la sélection parmi deux signaux respectivement S9 et S10, ou S7 et S8, la personne du métier pourra adapter le nombre de commutateurs au nombre de signaux à sélectionner en ajoutant un commutateur par signal à sélectionner en plus et en ajoutant au moins une inductance par commutateur additionnel, chaque inductance additionnelle étant en série avec les inductances 706, 707, 708, 709 et agencée pour pouvoir réaliser un couplage électromagnétique avec le ou les inductances 506, 507 des commutateurs additionnels. De plus, le multiplexeur 900 pourra être mis en œuvre en utilisant les commutateurs 700 ou 800 à la place des commutateurs 930, 940.

Enfin, la mise en œuvre pratique des modes de réalisation et variantes décrits est à la portée de la personne du métier à partir des indications fonctionnelles données ci-dessus. En particulier, les exemples des figures 5 à 9 peuvent être envisagés dans le cas d'un signal qui n'est pas différentiel mais qui serait uniquement appliqué sur le nœud N4 ou N4' par exemple de chaque commutateur. Dans ce cas, la deuxième inductance 507 des commutateurs serait par exemple absente ou serait dans une configuration asymétrique (single-ended en anglais) où son électrode opposée à celle reliée, préférentiellement connectée, au nœud NM serait laissée à un potentiel flottant. Additionnellement, même si les exemples des figures 5 et 9 illustrent un étage secondaire avec quatre inductances en série, la personne du métier pourra envisager seulement deux inductances en série, du moment qu'elles puissent permettre, chacune, un couplage électromagnétique satisfaisant avec les inductances 506, 507 du commutateur respectif. Autrement dit, le secondaire du multiplexeur peut être constitué d'inductances en série avec une seule inductance par commutateur présent au primaire.

## Revendications

1. Circuit de commutation (205) comprenant au moins un premier transistor bipolaire configuré pour être couplé à au moins un composant électrique (106, 109, 506, 507) à commuter, le transistor bipolaire (60) ayant une première électrode de conduction couplée à un potentiel électrique de référence par l'intermédiaire d'au moins un composant résistif (61) ou inductif ou un deuxième transistor (71).

2. Circuit de commutation selon la revendication 1, dans lequel :
- le transistor bipolaire (60) est de type NPN ; et/ou
- la première électrode de conduction dudit au moins un transistor bipolaire (60) correspond à l'émetteur du transistor bipolaire ; et/ou
- le circuit de commutation (205) comporte en outre une première résistance électrique (63) dont une première borne est couplée à une base du transistor bipolaire (60) et dont une deuxième borne est configurée pour être reliée à un rail d'application d'un premier signal de commande (S1); et/ou
- ledit composant résistif ou inductif correspond à une deuxième résistance électrique (61) ou une inductance, et comporte une première borne couplée à la première électrode de conduction du transistor bipolaire (60) et une deuxième borne couplée audit potentiel électrique de référence ; et/ou
- la première électrode de conduction du transistor bipolaire (60) est couplée à une première borne de conduction du deuxième transistor (71), et dans lequel une deuxième borne de conduction du deuxième transistor, par exemple de type NMOS ou PMOS, est couplée au potentiel électrique de référence.

3. Circuit de commutation selon la revendication 2, comportant en outre une troisième résistance électrique (65) dont une première borne est couplée à une électrode de commande du deuxième transistor (71) et dont une deuxième borne est reliée à un rail d'application d'un deuxième signal de commande (S2).

4. Circuit de commutation selon la revendication 3, dans lequel les premiers et deuxièmes signaux de commande (S1, S2) correspondent à un même signal de commande ou à deux signaux simultanés.

5. Circuit de commutation selon l'une quelconque des revendications précédentes, dans lequel :
- ladite première électrode dudit au moins un transistor bipolaire (60) est configurée pour être couplée audit composant électrique à commuter ; et/ou
- une deuxième électrode dudit au moins un transistor bipolaire (60) est configurée pour être couplée à un autre composant électrique à commuter.

6. Circuit de commutation selon l'une quelconque des revendications précédentes, dans lequel ledit potentiel électrique de référence est la masse.

7. Composant à valeur contrôlable, comprenant :
- un premier circuit de commutation (205) selon l'une quelconque des revendications précédentes ; et
- un premier composant électrique à commuter (106, 109, 506, 507), couplé à la première ou à une deuxième électrode dudit au moins un transistor bipolaire (60) dudit premier circuit de commutation (205) ;
ledit premier composant électrique à commuter correspondant à une capacité électrique ou une résistance électrique ou une inductance ou un transistor.

8. Composant à valeur contrôlable selon la revendication précédente, comprenant un deuxième composant électrique à commuter (106, 109, 506, 507), couplé à la deuxième électrode dudit au moins un transistor bipolaire dudit premier circuit de commutation ;
ledit premier composant électrique à commuter étant couplé à la première électrode dudit au moins un transistor bipolaire (60) dudit premier circuit de commutation ;
ledit deuxième composant électrique à commuter (106, 109, 506, 507) correspondant à une capacité électrique ou une résistance électrique ou une inductance ou un transistor.

9. Commutateur (500, 510) comprenant :
- un premier circuit de commutation selon l'une quelconque des revendications 1 à 6 ; et
- un premier composant électrique à commuter (506, 507), couplé à la deuxième électrode dudit au moins un transistor bipolaire dudit premier circuit de commutation (505) ;
ledit premier composant électrique à commuter correspondant à une première inductance (506) en série avec une deuxième inductance (507).

10. Commutateur selon la revendication 9, dans lequel une capacité (509) relie un point milieu (NM) des premières et deuxièmes inductances (506, 507) à la masse.

11. Commutateur selon la revendication 10, dans lequel la deuxième électrode dudit au moins un transistor bipolaire et une première borne de la première inductance (506), différente d'une deuxième borne de la première inductance (506) reliée au point milieu (NM) des premières et deuxièmes inductances, sont configurées pour être reliées à un premier nœud (N4) de réception ou d'application d'un signal différentiel (S7, S8).

12. Commutateur selon la revendication 11, comprenant un deuxième transistor bipolaire (515) ayant :
- un émetteur relié à la première électrode dudit au moins un transistor bipolaire dudit premier circuit de commutation (505) ; et
- un collecteur relié à une borne de la deuxième inductance (507), différente d'une autre borne reliée au point milieu (NM), et à un deuxième nœud (N5) d'application ou de réception dudit signal différentiel (S7, S8).

13. Commutateur selon la revendication 12 dans sa dépendance à la revendication 2, dans lequel une quatrième résistance (564) relie la base dudit deuxième transistor bipolaire (515) et le rail d'application du premier signal de commande (S1).

14. Multiplexeur (1000), comprenant :
- plusieurs commutateurs (500, 510) selon l'une quelconque des revendications 9 à 13 ;
- une pluralité de groupes d'inductances en série (706, 707, 708, 709) entre deux nœuds de sortie (NOUT4, NOUT5) du multiplexeur ;
chaque groupe d'inductance (706, 707) étant agencé de sorte qu'un couplage électromagnétique (1001, 1002) puisse se créer respectivement entre la première inductance (506) d'un desdits commutateurs (500) et une inductance (706) du groupe ainsi qu'entre la deuxième inductance (507) dudit commutateur (500) et une autre inductance (707) dudit groupe.

15. Multiplexeur (1000) selon la revendication 14, comprenant :
- au moins un premier commutateur (500) selon l'une quelconque des revendications 9 à 13 ;
- au moins un deuxième commutateur (510) selon l'une quelconque des revendications 9 à 13 ;
des troisièmes, quatrièmes, cinquièmes et sixièmes inductances en série (706, 707, 708, 709) entre les nœuds de sortie (NOUT4, NOUT5) du multiplexeur ;
les troisièmes et quatrièmes inductances (706, 707) étant agencées de sorte qu'un couplage électromagnétique (1001, 1002) puisse se créer respectivement entre la première inductance (506) du premier commutateur (500) et la troisième inductance (706) ainsi qu'entre la deuxième inductance (507) du premier commutateur (500) et la quatrième inductance (707) ;
les cinquièmes et sixièmes inductances (708, 709) étant agencées de sorte qu'un couplage électromagnétique (1003, 1004) puisse se créer entre la première inductance (506) du deuxième commutateur (510) et la cinquième inductance (708) ainsi qu'entre la deuxième inductance (507) du deuxième commutateur (510) et la sixième inductance (709).

16. Procédé de commande d'un composant à valeur contrôlable selon l'une quelconque des revendications 7 à 8, comprenant un changement d'une valeur du composant à valeur variable par la commutation dudit au moins un transistor bipolaire (60) dudit premier circuit de commutation (205); ou
procédé de commande d'un commutateur selon l'une quelconque des revendications 9 à 13, comprenant la mise en court-circuit des premières et deuxièmes inductances (506, 507) par la commutation dudit au moins un transistor bipolaire dudit premier circuit de commutation ; ou
procédé de commande d'un multiplexeur selon la revendication 14 ou 15, comprenant la sélection d'un signal à transmettre par le changement d'état du signal de commande respectif (S1, S1') d'au moins un parmi lesdits commutateurs (500, 510).
